# EUROPÄISCHE PATENTSCHRIFT

(11) **EP 2 567 602 B1**
(45) Veröffentlichungstag und Bekanntmachung des Hinweises auf die Patenterteilung: **26.02.2014**
(21) Anmeldenummer: 11738948.6
(22) Anmeldetag: 23.03.2011
(51) Int. Cl.: H05K 3/02

(54) **VERFAHREN ZUM EINBRINGEN ELEKTRISCHER ISOLIERUNGEN IN LEITERPLATTEN**
METHOD FOR INTRODUCING ELECTRICAL INSULATIONS IN PRINTED CIRCUIT BOARDS
PROCÉDÉ POUR MÉNAGER DES ISOLATIONS ÉLECTRIQUES DANS DES CARTES DE CIRCUIT IMPRIMÉ

(30) Priorität: 04.05.2010 DE 102010019407
(43) Veröffentlichungstag der Anmeldung: 13.03.2013
(73) Patentinhaber: LPKF Laser & Electronics AG, 30827 Garbsen (DE)
(72) Erfinder: VAN AALST, Jan, 30890 Barsinghausen (DE)
(74) Vertreter: Scheffler, Jörg
(86) Internationale Anmeldenummer: PCT/DE2011/075048
(87) Internationale Veröffentlichungsnummer: WO 2011/137897

(56) Entgegenhaltungen:
- WO-A1-2009/117979
- DE-A1- 4 429 522
- JP-A- 1 073 090
- JP-A- 4 116 887
- JP-A- 4 208 591

## Beschreibung

Die Erfindung betrifft ein Verfahren zum Einbringen elektrischer Isolierungen in verschiedene Bereiche einer Leiterplatte durch Einbringen einer Ausnehmung zwischen diesen Bereichen einer elektrisch leitfähigen Schicht auf einem Substrat, indem die nutenförmige Ausnehmung entlang einer Bearbeitungsbahn mittels eines thermischen Energieeintrags selektiv in die leitfähige Schicht eingebracht wird und die Endabschnitte einer oder verschiedener Ausnehmungen miteinander verbunden werden.

Derartige sogenannte schreibende Verfahren zur Erzeugung elektrisch isolierter Leiterbahnen, beispielsweise bei der Herstellung von Schaltungsträgern, sind bereits durch die DE 10 2004 006 414 B4 bekannt, bei der zum partiellen Abtragen definierter Bereiche diese selektiv mittels Laserstrahlung zur Verringerung der Adhäsion erwärmt und die Bereiche dann als Ganzes entfernt werden. Um die Erwärmung auf die definierten Bereiche zu beschränken, wird zunächst am Umfang dieser Bereiche mittels des Laserstrahls eine thermische Isolierung durch Einbringen einer linienförmigen Ausnehmung mittels des Laserstrahls erzeugt.

Die DE 44 29 522 A1 lehrt bereits ein Verfahren zum Einbringen elektrischer Isolierungen in eine Leiterplatte durch Einbringen einer Ausnehmung zwischen verschiedenen Bereichen einer elektrisch leitfähigen Schicht auf einem Substrat, wobei die nutenförmige Ausnehmung entlang einer Bearbeitungsbahn mittels eines thermischen Energieeintrags eines Laserstrahls selektiv in die leitfähige Schicht eingebracht wird. Dort werden die Endabschnitte derselben oder verschiedener Ausnehmungen miteinander verbunden, wobei zur Isolierung der verschiedenen Bereiche die Endabschnitte einer oder verschiedener Ausnehmungen in sich deckenden, parallelen Linien eingebracht werden.

Die DE 32 45 272 A1 betrifft ein Verfahren zur Herstellung von miniaturisierten, auf einem Trägersubstrat angeordneten und zumindest in einer Ebene liegenden Leiterbahngeometrien. Dabei sind die in der aus leitendem Material auf einem Substrat bestehenden vollflächigen Schicht mittels eines programmierten Lasers erzeugten Brennspuren so geführt, dass sich eine Induktivität ergibt.

Die US 5,525,205 A beschreibt bereits ein Verfahren zum partiellen Lösen einer definierten Fläche einer leitfähigen Schicht, insbesondere Kupferschicht, mittels eines Laserstrahls, bei dem die Laserstrahl-Parameter derart ein gestellt werden, dass lediglich die leitfähige Schicht abgetragen wird, ohne dass dabei zugleich auch ein darunterliegendes, die leitfähige Schicht tragendes Substrat beeinträchtigt wird, wobei die Fläche durch Abtragen der leitfähigen Schicht in ihrem äußeren Randbereich gegenüber den angrenzenden Bereichen der leitfähigen Schicht isoliert wird. Die eingeschlossene Fläche der leitfähigen Schicht wird dann durch chemisches Abtragen entfernt.

Die US 6,662,439 B1 offenbart bereits ein Verfahren zur Laserablation einer metallischen Schicht von einem flexiblen Trägermaterial im Durchlaufveriahren. Bei dem Trägermaterial handelt es sich um ein Polymer, beispielsweise Polyester, welches eine dünne metallische Schicht, beispielsweise aus Gold, trägt, die mittels eines Excimer-Lasers selektiv abgetragen wird.

Weiterhin bezieht sich die US 5,759,416 A auf ein Verfahren zur Laserablation einer dünnen metallischen Schicht von einem nichtmetallischen Trägermaterial. Bei der metallischen Schicht handelt es sich beispielsweise um Gold. Die Ablation der metallischen Schicht erfolgt mittels eines fokussierten Laserstrahls, welcher entlang einer vorprogrammierten Bahn verfahren wird.

Aus der EP 0 834 191 B1 ist ein Verfahren zum Laserabtrag von leitfähigen Schichten durch Verminderung der Adhäsion zwischen Leitschicht und Trägersubstrat bekannt. Ähnliche Verfahren sind auch aus der US 2003/0047280 A1 sowie der JP 2003047841 A bekannt.

Als problematisch erweist sich in der Praxis bei dem Verfahren die Steuerung der Ausnehmungen in ihren jeweiligen Endabschnitten, die in ihren Start- bzw. Endpunkten einander überschneiden oder tangieren. Insbesondere ist es dabei für die zuverlässige elektrische Isolierung von entscheidender Bedeutung, dass die leitfähige Schicht auch in den Endabschnitten der Ausnehmung entfernt wird, um einen Kurzschluss zu vermeiden. Idealerweise treffen die Ausnehmungen also direkt aufeinander, ohne jedoch einander wesentlich zu überlappen.

Falls die Ausnehmungen einander überlappen, trifft der Laserstrahl nicht auf die leitfähige Schicht, sondern aufgrund der zuvor bereits entfernten Schicht direkt auf das Substrat als Trägermaterial, welches dadurch geschädigt werden kann. Außerdem führt der nochmalige Energieeintrag zu einer Verbreiterung der Ausnehmung mit der Folge, dass eine Beeinträchtigung benachbarter Leiterbahnen nicht ausgeschlossen ist. Im Ergebnis führt also nur das in den Endabschnitten im Wesentlichen überlappungsfreie, unmittelbar aneinander angrenzende Einbringen der Ausnehmungen zu einem optimalen Arbeitsergebnis. Als problematisch erweist sich jedoch, dass diese Anforderungen an die Steuerung prinzipiell zu einer Null-Toleranzanforderung führen, die in der Praxis nicht erfüllbar ist.

Man könnte daran denken, zwar einen Überlappungsbereich der Endbereiche der Ausnehmungen zuzulassen, zugleich jedoch den thermischen Energieeintrag in diesem Überlappungsbereich zu reduzieren, um eine mögliche Schädigung des Substrats zu vermeiden. Dieser Lösungsansatz führt dennoch nicht zu dem gewünschten Erfolg, weil bei einer bereits geringfügigen Abweichung der Sollposition von der Istposition des Endabschnitts der reduzierte Energieeintrag in diesem Bereich nicht mehr ausreicht, um die erforderliche elektrische Isolierung sicherzustellen. Sofern man versuchen wollte, den thermischen Energieeintrag in Abhängigkeit des zuvor erfassten Überlappungsbereichs zu regeln, wäre dies mit einem erheblichen Zusatzaufwand verbunden, welcher zu einer Verzögerung der Herstellung führen würde.

Der Erfindung liegt die Aufgabe zugrunde, eine Möglichkeit zu schaffen, die gewünschte zuverlässige elektrische Isolierung der verschiedenen Bereiche durch Einbringen der Ausnehmung auch für solche Bearbeitungssituationen sicherzustellen, in denen es beim Einbringen der Ausnehmungen in ihren Endabschnitten zu Abweichungen von der jeweiligen Sollposition kommt.

Diese Aufgabe wird erfindungsgemäß mit einem Verfahren gemäß den Merkmalen des Anspruchs 1 gelöst. Die weitere Ausgestaltung der Erfindung ist den Unteransprüchen zu entnehmen.

Erfindungsgemäß ist also ein Verfahren vorgesehen, bei dem die zu verbindenden Endabschnitte einer oder verschiedener Ausnehmungen zur Isolierung der verschiedenen Bereiche parallel zueinander derart ohne Überlappung eingebracht werden, dass ein streifenförmiger Bereich der leitfähigen Schicht zwischen diesen Endabschnitten der Ausnehmungen zunächst erhalten bleibt. Die Erfindung geht dabei von der überraschenden Erkenntnis aus, dass der in den Endabschnitten parallele Verlauf derselben Ausnehmung oder verschiedener Ausnehmungen eine zuverlässige Isolierung sicherstellt, indem nämlich auch bei einer Abweichung der Istposition von der Sollposition eine zu einem Kurzschluss führende elektrische Brücke entfernt wird. Die Erfindung macht sich dabei den physikalischen Effekt zunutze, dass bei einem parallel beabstandeten Verlauf der Endabschnitte bei einer Abweichung ein streifenförmiger Bereich der leitfähigen Schicht zwischen diesen Endabschnitten der Ausnehmung zunächst erhalten bleibt. Einer Wärmeeinleitung beim Einbringen der Ausnehmungen in die angrenzenden Endabschnitte der leitfähigen Schicht steht jedoch die wesentlich verminderte Wärmeabgabe bzw. Wärmeweiterleitungsmöglichkeit des eingeschlossenen, thermisch weitgehend isolierten Bereichs gegenüber, sodass die eingeleitete Wärme lediglich über die Stirnflächen des streifenförmigen Bereichs abgeleitet werden kann. Im Ergebnis reicht bereits dieser indirekte Wärmeeintrag aus, um ein zuverlässiges Ablösen des streifenförmigen Bereichs sicherzustellen, sodass also weder eine Überlappung der Ausnehmungen noch eine unmittelbar aneinander angrenzende Position der Endabschnitte der Ausnehmung zur elektrischen Isolierung erforderlich ist. Das Steuerungsprogramm kann somit erfindungsgemäß derart gewählt werden, dass als Sollposition nicht die Übereinstimmung der Endpositionen beim Einbringen der Ausnehmungen vorgesehen ist, sondern deren paralleler Verlauf mit einem geringen Abstand, wobei der Abstand so gewählt ist, dass mögliche Toleranzeinflüsse das sichere Ablösen des streifenförmigen Bereichs nicht beeinträchtigen.

Die Endabschnitte könnten bereits durch eine Verlängerung der entlang paralleler Geraden verlaufenden Ausnehmungen erreicht werden, sodass die Endabschnitte parallel und zueinander benachbart verlaufen. Besonders Erfolg versprechend ist hingegen eine Abwandlung, bei welcher die Endabschnitte als eine Kurve oder eine Abwinkelung der Ausnehmungen eingebracht werden. Hierdurch wird der für den parallelen Verlauf erforderliche Platzbedarf wesentlich vermindert und zugleich ein von dem Verlauf und der jeweiligen Orientierung der Ausnehmungen unabhängiger paralleler Verlauf der Endabschnitte erreicht. Beispielsweise kann hierzu eine insbesondere rechtwinklige Abwinkelung oder ein spiralförmiger Verlauf vorgesehen sein, welcher innerhalb einer relativ kleinen Fläche eine vergleichsweise große Länge der parallel verlaufenden Endabschnitte gestattet.

Bei einer weiteren, ebenfalls besonders Erfolg versprechenden Abwandlung des Verfahrens, bei welcher die Endabschnitte zumindest abschnittsweise entlang paralleler Geraden verlaufen und zwischen sich einen streifenförmigen Bereich der Schicht konstanter Breite einschließen, kann aufgrund der bekannten Toleranzen bei der Durchführung des Verfahrens eine Überlappung der Endabschnitte ausgeschlossen und dennoch zugleich das Ablösen des streifenförmigen Bereichs der leitfähigen Schicht aufgrund des indirekten Energieeintrags, beispielsweise auch mittels einer zusätzlichen Fluidströmung, sichergestellt werden.

Dabei ist es besonders vorteilhaft, wenn die zu verbindenden Ausnehmungen entlang paralleler Bearbeitungsbahnen und die Endabschnitte im Wesentlichen rechtwinklig zu den

Bearbeitungsbahnen eingebracht werden. Hierdurch wird eine besonders zuverlässige Isolierung mittels der Ausnehmungen erreicht, wobei zudem eine Überlappung eines Endabschnitts mit anderen Abschnitten derselben Ausnehmung ausgeschlossen ist.

Weiterhin ist es in der Praxis von besonderem Vorteil, wenn die Länge jedes Endabschnitts in Abhängigkeit der Parameter der elektrisch leitfähigen Schicht oder des thermischen Energieeintrags bestimmt wird. Hierdurch wird die Länge des Endabschnitts auf einen jeweils zweckmäßigen Betrag beschränkt, sodass insbesondere unnötige Arbeitsgänge sowie ein unerwünschter zusätzlicher Platzbedarf vermieden werden können.

Grundsätzlich könnte beim Einbringen der Endabschnitte der Ausnehmungen eine zunehmende Breite durch eine Strahlaufweitung des Laserstrahls vorgesehen werden, um so in Teilabschnitten eine Überlappung bzw. Berührung der verschiedenen Endabschnitte, insbesondere auch in Verbindung mit einer in diesen Teilabschnitten reduzierten Leistungsdichte, zu erzeugen. Besonders einfach ist hingegen eine Ausgestaltung des Verfahrens, bei der jeder Endabschnitt eine entlang seiner Haupterstreckung konstante Breite aufweist, um so das Verfahren ohne aufwendigen Regelkreis schnell und zuverlässig einbringen zu können.

Indem in einem Bereich zwischen den Endabschnitten, insbesondere parallel zu diesen, entlang der geometrischen Mitte zwischen den Endabschnitten eine zusätzliche Schwächung oder Ausnehmung in die leitfähige Schicht eingebracht wird, können auch bei größeren Abweichungen die entsprechenden Isolierungen zuverlässig eingebracht werden.

Das Verfahren ist dabei nicht lediglich auf elektrische Isolierungen beschränkt. Vielmehr erweist es sich auch als praxistauglich, wenn die Ausnehmungen zwischen den Bereichen der thermischen oder mechanischen Trennung bzw. Isolierung dieser Bereiche dienen, und beispielsweise das flächige Ablösen der derart eingeschlossenen Bereiche begünstigen.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt in einer Prinzipdarstellung in
- Fig. 1: zwei nach dem erfindungsgemäßen Verfahren eingebrachte Ausnehmungen mit zueinander beabstandeten, parallelen Endabschnitten;
- Fig. 2: eine Variante der Ausnehmungen mit abgewinkelten Endabschnitten;
- Fig. 3: eine Variante der Ausnehmungen, bei welcher die Endabschnitte unmittelbar aneinandergrenzen;
- Fig. 4: eine weitere Variante der Ausnehmungen, bei welcher die Endabschnitte einander überdecken.

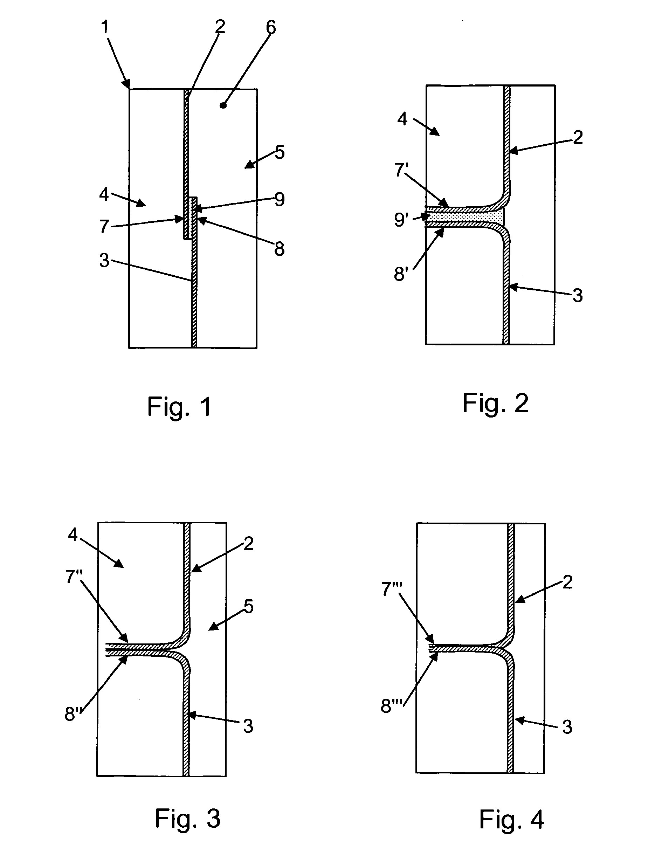

Das erfindungsgemäße Verfahren wird nachstehend anhand der Figuren 1 bis 4 näher dargestellt. Durch das Verfahren werden elektrische Isolierungen in eine Leiterplatte 1 durch Einbringen separater Ausnehmungen 2, 3 zwischen verschiedenen Bereichen 4, 5 einer elektrisch leitfähigen Schicht 6 auf einem nicht weiter dargestellten Substrat erzeugt. Hierzu werden die Ausnehmungen 2, 3 entlang einer Bearbeitungsbahn mittels eines nicht gezeigten Laserstrahls als nutenförmige Aussparungen in die leitfähige Schicht 6 eingebracht. Um hier die elektrische Isolierung zwischen den Bereichen 4, 5 sicherzustellen, ohne dass sich die Stirnflächen berühren müssen, verlaufen die Endabschnitte 7, 8 der Ausnehmungen 2, 3 entlang paralleler Geraden und schließen zwischen sich einen streifenförmigen Bereich 9 konstanter Breite ein. Aufgrund der Wärmeeinleitung beim Einbringen der Endabschnitte 7, 8 werden die Adhäsionskräfte des streifenförmigen Bereichs 9 derart herabgesetzt, dass sich dieser selbstständig von dem Substrat löst oder unter Zuhilfenahme eines Druckluftstrahls mühelos entfernt werden kann. Eine auf diesen streifenförmigen Bereich 9 gerichtete, direkte Laserstrahlung ist daher nicht erforderlich, sodass kein zusätzlicher Arbeitsgang erforderlich wird. Um ein zuverlässiges Ablösen des streifenförmigen Bereichs 9 sicherzustellen, ist also weder eine Überlappung der Ausnehmungen 2, 3 noch eine unmittelbar aneinander angrenzende Position der Endabschnitte 7, 8 der Ausnehmungen 2, 3 zur elektrischen Isolierung erforderlich. In Figur 1 wird das Einbringen der Endabschnitte 7, 8 als benachbarter Verlauf paralleler Ausnehmungen 2, 3 dargestellt. Demgegenüber sind die Endabschnitte 7', 8' gemäß Figur 2 jeweils als Abwinkelungen der Ausnehmungen 2, 3 eingebracht, die so einen in den Bereich 4 hineinreichenden, streifenförmigen Bereich 9' selbst dann zuverlässig einschließen, wenn die Haupterstreckungsachsen der Ausnehmungen 2, 3 einen unbeabsichtigten Versatz aufweisen. Dabei hängt die Auswahl der jeweiligen Gestaltung der Endabschnitte 7, 7', 8, 8' maßgeblich von dem übrigen, nicht dargestellten Leiterplattenbild ab. Sofern es in der Praxis zu Abweichungen kommt, betreffen diese die in den Figuren 3 und 4 dargestellten Fälle, bei denen gemäß Figur 3 ein unmittelbar aneinandergrenzender Verlauf der Endabschnitte 7", 8" realisiert ist, mit der Folge einer optimalen Isolierung der Bereiche 4, 5. In dem in Figur 4 dargestellten Fall kommt es hingegen zu einer Überlappung der Endabschnitte 7"', 8'" und damit zu einer Einwirkung des Laserstrahls auf das Substrat mit der Folge einer Verbreiterung der Ausnehmungen 2, 3. Durch die Abwinkelung verlagert sich dieser Einflussbereich jedoch in einen für die Funktion der Leiterplatte unkritischen Bereich, woraus sich je nach Ausprägung des Leiterplattenbilds auch der Vorteil gegenüber der in Figur 1 gezeigten Variante ableitet.

## Patentansprüche

1. Verfahren zum Einbringen elektrischer Isolierungen in eine Leiterplatte (1) durch Einbringen einer Ausnehmung (2, 3) zwischen verschiedenen Bereichen (4, 5) einer elektrisch leitfähigen Schicht (6) auf einem Substrat, indem die nutenförmige Ausnehmung (2, 3) entlang einer Bearbeitungsbahn mittels eines thermischen Energieeintrags selektiv in die leitfähige Schicht (6) eingebracht wird und die Endabschnitte (7, 7', 8, 8') derselben und/oder verschiedener Ausnehmungen (2, 3) miteinander verbunden werden, **dadurch gekennzeichnet, dass** zur Isolierung der verschiedenen Bereiche (4, 5) die Endabschnitte (7, 7', 8, 8') einer oder verschiedener Ausnehmungen (2, 3) parallel zueinander derart ohne Überlappung eingebracht werden, dass ein streifenförmiger Bereich (9, 9') der leitfähigen Schicht (6) zwischen diesen Endabschnitten (7, 7', 8, 8') der Ausnehmungen (2, 3) zunächst erhalten bleibt.

2. Verfahren nach Anspruch 1, **dadurch gekennzeichnet, dass** die Endabschnitte (7, 7', 8, 8') als eine Kurve oder ein Abwinkelung der Ausnehmungen (2, 3) eingebracht werden.

3. Verfahren nach den Ansprüchen 1 oder 2, **dadurch gekennzeichnet, dass** die zu verbindenden Ausnehmungen (2, 3) entlang paralleler Bearbeitungsbahnen und die jeweiligen Endabschnitte (7, 7', 8, 8') im Wesentlichen rechtwinklig zu den Bearbeitungsbahnen eingebracht werden.

4. Verfahren nach zumindest einem der vorhergehenden Ansprüche, **dadurch gekennzeichnet, dass** die Endabschnitte (7, 7', 8, 8') zumindest abschnittsweise entlang paralleler Geraden verlaufen und zwischen sich den streifenförmigen Bereich (9, 9') der Schicht konstanter Breite begrenzen.

5. Verfahren nach Anspruch 1, **dadurch gekennzeichnet, dass** der zwischen den Endabschnitten (7, 7', 8, 8') begrenzte streifenförmige Bereich (9, 9') mittels einer Fluidströmung entfernt wird.

6. Verfahren nach zumindest einem der vorhergehenden Ansprüche, **dadurch gekennzeichnet, dass** jeder Endabschnitt (7, 7', 8, 8') eine entlang seiner Haupterstreckung konstante Breite aufweist.

7. Verfahren nach zumindest einem der vorhergehenden Ansprüche, **dadurch gekennzeichnet, dass** in einem Bereich zwischen den Endabschnitten (7, 7', 8, 8'), insbesondere in einer geometrischen Mitte, eine zusätzliche Schwächung und/oder Ausnehmung in die leitfähige Schicht (6) auf dem Substrat eingebracht wird.

8. Verfahren nach zumindest einem der vorhergehenden Ansprüche, **dadurch gekennzeichnet, dass** der thermische Energieeintrag mittels eines Laserstrahls erfolgt.

## Claims

1. Method for introducing electrical insulations into a printed circuit board (1) by introducing a recess (2, 3) between different regions (4, 5) of an electrically conductive layer (6) on a substrate, in that the groove-shaped recess (2, 3) is selectively introduced into the conductive layer (6) along a machining path by means of a thermal energy input and the end portions (7, 7', 8, 8') of the same and/or different recesses (2, 3) are connected to one another, **characterized in that**, to insulate the different regions (4, 5), the end portions (7, 7', 8, 8') of one or different recesses (2, 3) are introduced parallel to one another without overlap in such a way that a strip-shaped region (9, 9') of the conductive layer (6) between these end portions (7, 7', 8, 8') of the recesses (2, 3) is initially retained.

2. Method according to Claim 1, **characterized in that** the end portions (7, 7', 8, 8') are introduced as a curve or a bend of the recesses (2, 3).

3. Method according to Claim 1 or 2, **characterized in that** the recesses (2, 3) to be connected are introduced along parallel machining paths and the respective end portions (7, 7', 8, 8') are introduced substantially at right angles to the machining paths.

4. Method according to one of the preceding claims, **characterized in that** the end portions (7, 7', 8, 8') extend at least in portions along parallel straight lines and delimit between them the strip-shaped region (9, 9') of the layer of constant width.

5. Method according to Claim 1, **characterized in that** the strip-shaped region (9, 9') delimited between the end portions (7, 7', 8, 8') is removed by means of a fluid flow.

6. Method according to at least one of the preceding claims, **characterized in that** each end portion (7, 7', 8, 8') has a constant width along its main extent.

7. Method according to at least one of the preceding claims, **characterized in that** an additional weakening and/or recess is introduced into the conductive layer (6) on the substrate in a region between the end portions (7, 7', 8, 8'), in particular in a geometrical centre.

8. Method according to at least one of the preceding claims, **characterized in that** the thermal energy input takes place by means of a laser beam.

## Revendications

1. Procédé pour réaliser des isolations électriques dans une carte à circuits imprimés (1) en réalisant un évidement (2, 3) entre différentes régions (4, 5) d'une couche électriquement conductrice (6) sur un substrat, l'évidement en forme de rainure (2, 3) étant réalisé de manière sélective dans la couche conductrice (6) le long d'une trajectoire d'usinage au moyen d'un apport d'énergie thermique et les portions d'extrémité (7, 7', 8, 8') de celui-ci et/ou de différents évidements (2, 3) étant connectées les unes aux autres, **caractérisé en ce que** pour l'isolation des différentes régions (4, 5), les portions d'extrémité (7, 7', 8, 8') d'un ou de différents évidements (2, 3) sont réalisées parallèlement les unes aux autres sans chevauchement de telle sorte qu'une région en forme de ruban (9, 9') de la couche conductrice (6) subsiste d'abord entre ces portions d'extrémité (7, 7', 8, 8') des évidements (2, 3).

2. Procédé selon la revendication 1, **caractérisé en ce que** les portions d'extrémité (7, 7', 8, 8') sont réalisées sous forme de courbe ou sous forme de coudage des évidements (2, 3).

3. Procédé selon les revendications 1 ou 2, **caractérisé en ce que** les évidements à connecter (2, 3) sont réalisés le long de trajectoires d'usinage parallèles et les portions d'extrémité respectives (7, 7', 8, 8') sont réalisées essentiellement à angle droit par rapport aux trajectoires d'usinage.

4. Procédé selon au moins l'une quelconque des revendications précédentes, **caractérisé en ce que** les portions d'extrémité (7, 7', 8, 8') s'étendent au moins en partie le long de droites parallèles et délimitent entre elles la région en forme de ruban (9, 9') de la couche de largeur constante.

5. Procédé selon la revendication 1, **caractérisé en ce que** la région (9, 9') en forme de ruban délimitée entre les portions d'extrémité (7, 7', 8, 8') est enlevée au moyen d'un écoulement de fluide.

6. Procédé selon au moins l'une quelconque des revendications précédentes, **caractérisé en ce que** chaque portion d'extrémité (7, 7', 8, 8') présente une largeur constante le long de son étendue principale.

7. Procédé selon au moins l'une quelconque des revendications précédentes, **caractérisé en ce que** dans une région entre les portions d'extrémité (7, 7', 8, 8'), notamment dans un centre géométrique, est réalisé un affaiblissement supplémentaire et/ou un évidement supplémentaire dans la couche conductrice (6) sur le substrat.

8. Procédé selon au moins l'une quelconque des revendications précédentes, **caractérisé en ce que** l'apport d'énergie thermique a lieu au moyen d'un faisceau laser.
